# EUROPEAN PATENT SPECIFICATION

(11) **EP 4 376 163 B1**
(45) Date of publication and mention of the grant of the patent: **28.10.2026**
(21) Application number: 22818164.0
(22) Date of filing: 11.07.2022
(51) Int. Cl.: H01M 10/48, G08B 17/00, G08B 21/18, A62C 3/16, H01M 10/42, G01R 31/36

(54) **BATTERY FIRE PREVENTION AND DIAGNOSIS SYSTEM**
BATTERIEBRANDSCHUTZ- UND -DIAGNOSESYSTEM
SYSTÈME DE PRÉVENTION ET DE DIAGNOSTIC D'INCENDIE DE BATTERIE

(30) Priority: 19.07.2021 KR 20210094145
(43) Date of publication of application: 29.05.2024
(73) Proprietor: Hyosung Heavy Industries Corporation, Seoul 04144 (KR)
(72) Inventor: JO, Hyang Eun, Tongyeong-si Gyeongsangnam-do 53042 (KR); SEO, Hwang Dong, Gimhae-si Gyeongsangnam-do 50975 (KR); JUNG, Jae Ryong, Gimhae-si Gyeongsangnam-do 50836 (KR)
(74) Representative: Viering, Jentschura & Partner mbB Patent- und Rechtsanwälte
(86) International application number: PCT/KR2022/010059
(87) International publication number: WO 2023/003242

(56) References cited:
- CN-U- 205 335 388
- JP-A- 2002 050 406
- KR-A- 20180 073 312
- KR-B1- 101 317 476
- KR-B1- 101 641 515
- KR-B1- 102 221 860
- KR-B1- 102 221 860
- US-A- 5 744 932
- US-A1- 2021 055 352

## Description

### FIELD OF THE INVENTION

The present invention relates to a system for detecting abnormality of a battery system and preventing fire; and more particularly to, the system for detecting abnormality of the battery system and preventing fire by using a high frequency current transformer (HFCT).

### BACKGROUND OF THE INVENTION

The recently rapidly increasing electricity demand requires the dissemination of new and renewable energy generating systems and the development of energy storage systems (ESS) by using batteries. An ESS is a large-capacity energy storage system that stores excessively generated power, and discharges it when power is insufficient. When using ESS, it is possible to reduce investment costs for new electricity generation facilities, and maximize energy production and use efficiency through linkage with new and renewable energy such as wind energy and solar energy.

Such ESS is composed of multiple batteries, a power conditioning system (PCS), etc. Herein, the PCS basically bidirectionally converts direct current (DC) power and alternating current (AC) power between a grid and a battery system, and also performs functions of improving reliability of a power grid, rapidly supplying stored energy upon peak demand for power, and so forth.

Meanwhile, as the number of installations of such ESS increases, the number of fire accidents arising from the increasing internal temperature of the ESS due to deterioration or failure of a battery system used in the ESS is gradually on the rise. Once a fire occurs, a heavy cost is required to return to the original condition, and it may give impacts even over stability of a power grid with which the ESS is connected.

The document US 2021/055352 A1 discloses monitoring the noise signals associated with micro-shorts in a battery which can lead to fires. Noise other than noise related to the micro-short is corrected using a signal with an opposite phase thereto.

Accordingly, the necessity of a measure to detect and prevent any fire before such fire occurs in an ESS is increasing.

### DETAILED EXPLANATION OF THE INVENTION

### OBJECTS OF THE INVENTION

An object of the present invention is to provide a battery fire prevention and diagnosis system capable of detecting abnormality of multiple batteries earlier by using a high frequency current transformer (HFCT).

The other object of the present invention is to provide the battery fire prevention and diagnosis system capable of preventing fire accidents caused by any defective battery because it is possible to detect any abnormality of the multiple batteries by using the HFCT.

### MEANS OF SOLVING THE PROBLEM

A battery fire prevention and diagnosis system in accordance with the present invention comprises: a high frequency current transformer installed to at least one of a ground wire, a positive wire, or a negative wire of a battery system; a data acquiring unit for receiving high frequency current signals measured from the HFCT; noise/defect cause database including on-site noise data related to a site in operation, and data on causes of defects; and a diagnosis unit for determining abnormality of the battery system, and a cause of a defect based on high frequency signal data acquired from the data acquiring unit, and the on-site noise data and the data on causes of defects in the noise/defect cause database.

At the time, the battery system may mean a battery rack comprised of a multiplicity of battery modules, each of which consists of multiple battery cells.

Herein, the diagnosis unit may primarily remove noise by comparing the high frequency signal data with the on-site noise data.

In addition, after the noise is primarily removed, the diagnosis unit may draw at least one of pulse size, wave, frequency, and time difference through signal analysis, and compare it with the data on causes of defects to determine abnormality and any cause of a defect.

Besides, if there is any abnormality of the battery system, the diagnosis unit may further estimate a defect location based on the pulse time difference to estimate an abnormal battery module or a battery cell.

Furthermore, the on-site noise data in the noise/defect cause database may be constructed by measuring on-site noise at a site currently in operation, and the data on causes of defects may be acquired in a way of simulating random battery defects, checking internal abnormal conditions, and constructing such causes of defects.

At the time, the HFCT may be installed together with clamps.

Meanwhile, the battery system may be equipped in an ESS.

### EFFECTS OF THE INVENTION

A battery fire prevention and diagnosis system in accordance with the present invention has an effect of being capable of detecting abnormalities of multiple batteries earlier by using a HFCT.

Besides, the battery fire prevention and diagnosis system in accordance with the present invention has an effect of being capable of preventing any fire accident caused by battery defects because it is possible to detect abnormalities of multiple batteries earlier by using the HFCT.

### BRIEF DESCRIPTION OF THE DRAWINGS

Fig. 1 is a block diagram illustrating a battery fire prevention and diagnosis system in accordance with an example embodiment of the present invention.
Fig. 2 is a workflow diagram of a battery fire prevention and diagnosis system in accordance with an example embodiment of the present invention.

### DETAILED DESCRIPTION OF THE PREFERRED EMBODIMENTS

Detailed example embodiments to implement the present invention will be explained below by referring to attached drawings.

Since the present invention may make a variety of modifications, and have several example embodiments, specific example embodiments will be illustrated in diagrams, and explained in details. This is not intended to limit specific embodiments which specify the present invention, and it may be understood to include all modifications included in the technical scope of the present invention as defined by the claims.

Detailed explanation will be made on a battery fire prevention and diagnosis system in accordance with the present invention by referring to the attached drawings.

First, causes of fire of an ESS and a process of fire occurrence will be explained.

Causes of fire of an ESS may be largely classified into the following types: defects in battery systems, lack of protection systems against electric shock, lack of management of an operating environment, careless installation, negligence in installation and operation management, etc.

Defects in battery systems may include continuous electric shock such as short circuit and ground fault, non-operation of a self-protection function of such battery systems, etc., while cases regarding lack of protection systems against electric shock may include external short circuit such as IGBT short circuit of a PCS, battery overdischarge, and overpotential, etc.

In addition, cases regarding lack of management of an operating environment and careless installations may include additional charging after a battery system is fully charged, increase in battery cell voltage, application of negative overpotential, etc.

Negligence in installation and operation management may include battery cell shock, wrong wiring, reduction in insulation resistance, etc.

When the operating period of the ESS is longer due to the aforementioned causes, defects of battery cells are accumulated in a battery system equipped in the ESS, and this causes a cell-swelling phenomenon, i.e., a battery swelling phenomenon.

At this state, deformation of battery stacks and partial rupture of a separator in a battery system occur, and fine short circuits occur inside battery cells, and these cause discharge inside the batteries.

Discharge inside batteries occurs due to partial rupture of insulation between electrodes or a separator, or fine short circuits inside battery cells with high frequency currents, electromagnetic waves, light, sound, gas, heat, etc.

After that, when battery deterioration continues, a phenomenon of deforming and degassing battery cells occurs, and upon occurrence of any abnormal battery system by installing systems for protecting such phenomenon, power, now, is shut down, or emitted gases are discharged through vent holes by installing vents.

However, even after the operation of such protective systems and vents, when such defect continuously develops, the battery cell is deformed due to resistance, and voltage of another cell is applied to the deformed battery cell. Finally, internal short circuits due to resistance heat continue, and lead occurrence of fire due to thermal runway.

Meanwhile, during each stage of ESS fire development as shown above, internal discharge in the battery system continues. At the early stage, it occurs intermittently, but when such defect gradually develops, discharge cycles increase.

To effectively prevent fire of ESS in advance, it is necessary to detect internal abnormalities in batteries during the early or pre-step of "deformation of battery stacks, partial rupture of separators, and fire short circuits in battery cells" in a fire mechanism other than electrical safety measures and fire safety measures such as supervision, protection, and extinguishment.

In other words, the fire mechanism for ESS proceeds in five steps (defect in a battery cell → cell swelling → a preventive system's operation → opening vent holes → fire), and factors possible to measure upon fire occurrence include internal discharge of the battery system, temperature, and off gas.

Among them, in case of internal discharge, high-frequent current is detected at each step, and in case of temperature, if there occurs any abnormality such as overcharge in the battery system, after the battery cell is swollen, a protective system operates without any rise in temperature, and therefore, it is not appropriate as factor for fire prevention. In addition, an off-gas monitoring system, which detects emitted gas due to any defect in a battery system, is difficult to be applied for fire prevention because it operates only when vent holes are opened.

Accordingly, the present invention is intended to measure internal discharge in a battery system through a HFCT that does not give any physical deformation and operating environment of the battery system itself, and to prevent fire in advance by detecting an internal discharge signal in a battery cell "before a protective system operates after the cell is swollen" during the process of fire of ESS.

The present invention is explained in detail by referring to attached drawings.

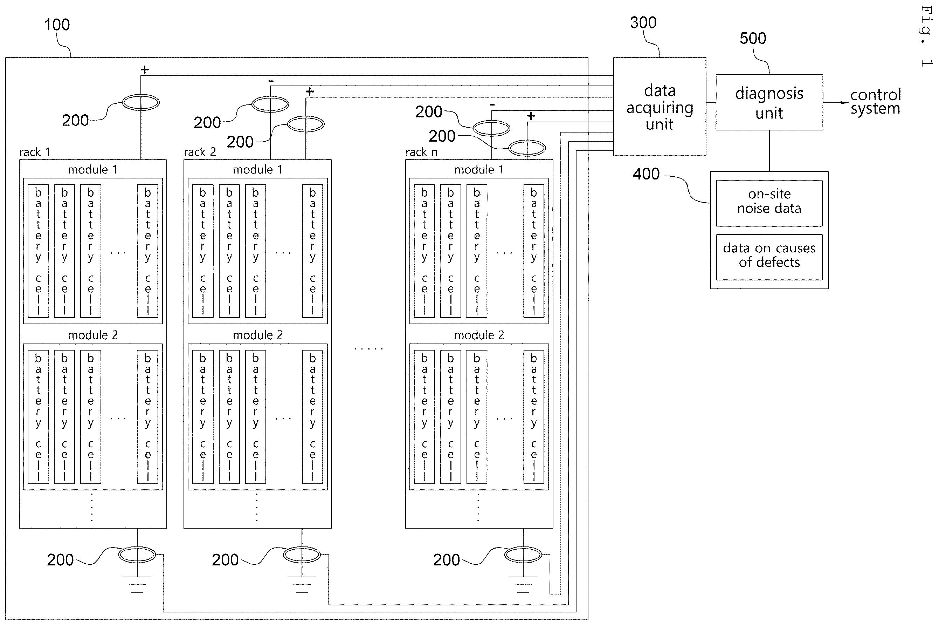

Fig. 1 is a block diagram illustrating a battery fire prevention and diagnosis system in accordance with an example embodiment of the present invention.

By referring to Fig. 1, the battery fire prevention and diagnosis system in accordance with one example embodiment of the present invention comprises: a high frequency current transformer 200 connected to at least one of a ground wire, a positive wire, or a negative wire of a battery system 100 together with clamps; a data acquiring unit 300 for receiving high frequency current signals measured from the HFCT 200; noise/defect cause database 400 including on-site noise data related to a site in operation, and data on causes of defects; and a diagnosis unit 500 for determining abnormality of the battery system, and a cause of a defect based on high frequency signal data acquired from the data acquiring unit 300, and the on-site noise data and the data on causes of defects in the noise/defect cause database 400.

Herein, the battery system 100 includes multiple battery cells. When this is explained in detail, a battery cell means one battery. A battery module is composed of such battery cells, and a battery rack is composed of a multiplicity of battery modules.

As seen in Fig. 1, the present invention has an effect of being capable of measuring multiple battery cells at the same time by using the HFCT 200 for the battery pack.

Fig. 1 illustrates a battery rack equipped with a multiplicity of battery modules composed of multiple battery cells as one example embodiment of the battery system 100, but this is one example embodiment. According to examples, and depending on necessity, a variety of modifications of number of battery cells or battery modules may be applied.

The HFCT 200 is a sensor that measures flowing high frequency currents upon partial rupture of a separator in the battery system, or fine short circuit in a battery cell.

When the HFCT 200 is used, a phenomenon of discharging any insulation due to any defect in the battery system may be measured, and this may lead a degree of deterioration to be effectively diagnosed. Since the HFCT 200 is largely influenced by noise while it has high measurement sensitivity, it is necessary to separate or remove noise regarding the measured signal.

In accordance with the present invention, the on-site noise data in the noise/defect cause database 400 may be constructed by measuring on-site noise at a site currently in operation, and the data on causes of defects is acquired in a way of constructing causes of defects by simulating random battery defects, and checking internal abnormal conditions and so forth.

Meanwhile, the diagnosis unit 500 diagnoses abnormality of the battery system 100, and a cause of a defect based on high frequency signal data acquired from the data acquiring unit 300, and the on-site noise data and the data on causes of defects in the noise/defect cause database 400, and transmits the result to a higher-ranked control system.

For this, the diagnosis unit 500 primarily removes noise by comparing the high frequency signal data with the on-site noise data stored in the noise/defect cause database 400. After that, the diagnosis unit 500 analyzes pulse size, wave, frequency, and pulse time difference through signal analysis, and determines abnormality and any cause of a defect by comparing them with the data on causes of defects stored in the noise/defect cause database 400. In addition, if there is any abnormality of the battery system 100, it estimates a defect location by using the pulse time difference, which means the time difference between pulses, to estimate an abnormal battery module or battery cell.

In accordance with the example embodiment, it is possible to simulate random battery defects and check internal abnormal conditions to obtain data on causes of defects in the noise/defect cause database 400 in a way of simulating battery cell swelling caused by overheating and overcharging due to internal defect, and measuring and analyzing internal discharging signals before the operation of a protective system.

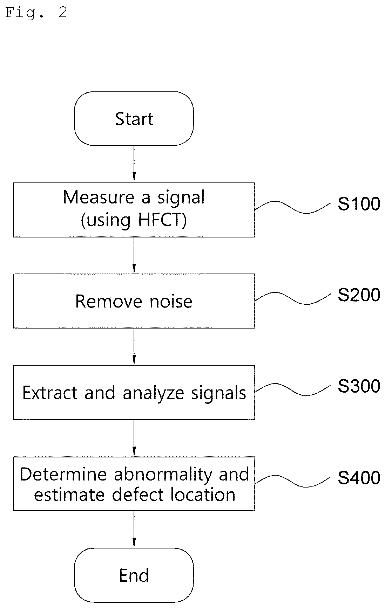

Next, the operation of the battery fire prevention and diagnosis system in accordance with the present invention is explained by referring to Fig. 2. Fig. 2 is a workflow diagram of a battery fire prevention and diagnosis system in accordance with an example embodiment of the present invention.

In accordance with the present invention, the battery fire prevention and diagnosis system first measures high frequency current signals of the battery system 100 through a HFCT 200 at S100. As the present invention may use the HFCT 200 for a battery rack, it is possible to measure from multiple battery cells at the same time.

After that, noise is removed by comparing high frequency signals of the measured current with on-site noise data stored in noise/defect cause database 400 at S200. Herein, on-site noise data may be constructed by measuring on-site noise at a site currently in operation.

As explained above, since the HFCT 200 is largely influenced by noise while it has high measurement sensitivity, noise is removed from the measured signal of the HFCT 200 at this step.

Signals are extracted and analyzed to draw pulse size, wave, frequency, and pulse time difference, etc. at S300.

The drawn pulse size, wave, frequency, and time difference, etc. are compared with data on causes of defects stored in the noise/defect cause database 400 to determine abnormality and any cause of a defect, and if there is any abnormality, a location of the defect is estimated by using the pulse time difference, which means the time difference between pulses, to estimate an abnormal battery module or battery cell at S400.

Herein, the data on causes of defects may be acquired in a way of being constructed by simulating random battery defects, and checking internal abnormal conditions. Depending on example embodiments, it may be acquired in a way of simulating battery cell swelling caused by heating and overcharging due to internal defect, etc. and measuring and analyzing internal discharging signals before the operation of a protective system.

As explained above, because the present invention uses the HFCT 200 for the battery rack, it is possible to measure from multiple battery cells at the same time. In addition, it has an effect of not only detecting abnormality of the battery system, and a cause of such defect but also estimating a location of an abnormal battery module or battery cell by using the pulse time difference.

Meanwhile, explanation has been made with an example of the battery system equipped with the ESS in the example embodiment of the present invention, but the present invention is not limited to this, and it could be applied to any apparatus or equipment that has a battery system including multiple battery cells.

As seen above, the battery fire prevention and diagnosis system in accordance with the present invention may detect abnormality of multiple batteries earlier by using the HFCT, and prevent any fire accident caused by any battery defect.

What has been explained above includes one or more example embodiments. Of course, for the purpose of explaining the aforementioned example embodiments, it can be recognized that not all possible combinations of components or methods could be described but a lot of additional combinations in a variety of example embodiments can be made by those of ordinary skill in the art. Accordingly, the explained example embodiments could include all modifications falling within the scope of what is claimed.

### Industrial Availability

The present invention relates to a system for preventing fire by detecting abnormality of a battery system, and it is available in ESS including batteries.

## Claims

1. A battery fire prevention and diagnosis system, **characterised by**:
a high frequency current transformer (200), HFCT, installed to at least one of a ground wire, a positive wire, or a negative wire of a battery system (100);
a data acquiring unit (300) for receiving high frequency current signals measured from the HFCT;
noise/defect cause database (400) including on-site noise data related to a site in operation, and data on causes of defects; and
a diagnosis unit (500) for determining abnormality of the battery system, and a cause of a defect based on high frequency signal data acquired from the data acquiring unit, and the on-site noise data and the data on causes of defects in the noise/defect cause database.

2. The system of Claim 1, wherein the battery system means a battery rack comprised of a multiplicity of battery modules, each of which consists of multiple battery cells.

3. The system of Claim 1, wherein the diagnosis unit primarily removes noise by comparing the high frequency signal data with the on-site noise data.

4. The system of Claim 3, wherein, after the noise is primarily removed, the diagnosis unit draws at least one of pulse size, wave, frequency, and time difference through signal analysis, and compares it with the data on causes of defects to determine abnormality and any cause of a defect.

5. The system of Claim 4, wherein, if there is any abnormality of the battery system, the diagnosis unit further estimates a defect location based on the pulse time difference to estimate an abnormal battery module or battery cell.

6. The system of Claim 1, wherein the on-site noise data in the noise/defect cause database is constructed by measuring on-site noise at a site currently in operation, and the data on causes of defects is constructed by simulating random battery defects, and checking internal abnormal conditions.

7. The system of Claim 1, wherein the HFCT is installed together with clamps.

8. The system of Claim 1, wherein the battery system is equipped in an energy storage system (ESS).

## Patentansprüche

1. Batteriebrand-Verhütungs- und Diagnose-System, **gekennzeichnet durch**:
einen Hochfrequenzstromwandler (200), HFCT, der an mindestens einem von einem Erdungsdraht, einem positiven Draht oder einem negativen Draht eines Batteriesystems (100) installiert ist,
eine Datenerlangungseinheit (300) zum Empfangen von Hochfrequenzstromsignalen, die vom HFCT gemessen werden,
eine Rausch-/Fehlerursachen-Datenbank (400), die Vor-Ort-Rauschdaten in Bezug auf einen in Betrieb befindlichen Ort und Daten zu Fehlerursachen aufweist, und
eine Diagnoseeinheit (500) zum Ermitteln einer Anomalie des Batteriesystems und einer Fehlerursache basierend auf von der Datenerlangungseinheit erlangten Hochfrequenzsignaldaten sowie den Vor-Ort-Rauschdaten und den Daten zu Fehlerursachen in der Rausch-/Fehlerursachen-Datenbank.

2. System gemäß Anspruch 1, wobei das Batteriesystem ein Batteriegestell bezeichnet, das aus einer Vielzahl von Batteriemodulen zusammengesetzt ist, wobei jedes davon aus mehreren Batteriezellen besteht.

3. System gemäß Anspruch 1, wobei die Diagnoseeinheit Rauschen im Wesentlichen durch Vergleichen der Hochfrequenzsignaldaten mit den Vor-Ort-Rauschdaten entfernt.

4. System gemäß Anspruch 3, wobei die Diagnoseeinheit, nachdem das Rauschen im Wesentlichen entfernt ist, durch Signalanalyse mindestens eines von einer Impulsgröße, Welle, Frequenz und Zeitdifferenz erhält, und dieses mit den Daten zu Fehlerursachen vergleicht, um eine Anomalie und jegliche Fehlerursache zu ermitteln.

5. System gemäß Anspruch 4, wobei die Diagnoseeinheit bei Vorliegen irgendeiner Anomalie des Batteriesystems ferner basierend auf der Impulszeitdifferenz einen Fehlerort berechnet, um ein anormales Batteriemodul oder eine anormale Batteriezelle zu berechnen.

6. System gemäß Anspruch 1, wobei die Vor-Ort-Rauschdaten in der Rausch-/Fehlerursachen-Datenbank durch Messen von Vor-Ort-Rauschen an einem derzeit in Betrieb befindlichen Ort erstellt werden und die Daten zu Fehlerursachen durch Simulieren zufälliger Batteriefehler und Überprüfen von internen anormalen Bedingungen erstellt werden.

7. System gemäß Anspruch 1, wobei der HFCT zusammen mit Klemmen installiert ist.

8. System gemäß Anspruch 1, wobei das Batteriesystem in einem Energiespeichersystem (ESS) eingebaut ist.

## Revendications

1. Système de prévention et de diagnostic d'incendie de batterie, **caractérisé par** :
un transformateur de courant haute fréquence (200), HFCT, installé sur au moins l'un parmi un fil de masse, un fil positif ou un fil négatif d'un système de batterie (100),
une unité d'acquisition de données (300) pour recevoir des signaux de courant haute fréquence mesurés depuis le HFCT,
une base de données de bruit/causes de défaut (400) comprenant des données de bruit sur site relatives à un site en fonctionnement, ainsi que des données sur des causes de défaut ; et
une unité de diagnostic (500) pour déterminer une anomalie du système de batterie, ainsi qu'une cause d'un défaut sur la base de données de signaux haute fréquence acquises depuis l'unité d'acquisition de données, et des données de bruit sur site et des données sur les causes de défaut dans la base de données de bruit/causes de défaut.

2. Système selon la revendication 1, dans lequel le système de batterie désigne un rack de batteries composé d'une multiplicité de modules de batteries, dont chacun est constitué de plusieurs cellules de batterie.

3. Système selon la revendication 1, dans lequel l'unité de diagnostic élimine principalement du bruit en comparant les données de signaux haute fréquence avec les données de bruit sur site.

4. Système selon la revendication 3, dans lequel, une fois le bruit éliminé principalement, l'unité de diagnostic détermine au moins l'une parmi une dimension d'impulsion, une onde, une fréquence et une différence de temps par analyse de signal, et la compare aux données sur les causes de défaut afin de déterminer une anomalie et toute cause de défaut.

5. Système selon la revendication 4, dans lequel, en cas d'anomalie du système de batterie, l'unité de diagnostic estime en outre un emplacement de défaut sur la base de la différence de temps d'impulsion afin d'identifier un module de batterie ou une cellule de batterie anormal.

6. Système selon la revendication 1, dans lequel les données de bruit sur site dans la base de données de causes de bruit/défaut sont constituées en mesurant du bruit sur site sur un site actuellement en fonctionnement, et les données relatives aux causes de défaut sont constituées en simulant des défauts aléatoires de batterie et en vérifiant des conditions anormales internes.

7. Système selon la revendication 1, dans lequel le HFCT est installé avec des pinces.

8. Système selon la revendication 1, dans lequel le système de batterie est intégré à un système de stockage d'énergie (ESS).
